# EUROPEAN PATENT SPECIFICATION

(11) **EP 2 056 658 B1**
(45) Date of publication and mention of the grant of the patent: **02.02.2011**
(21) Application number: 08162013.0
(22) Date of filing: 07.08.2008
(51) Int. Cl.: H05K 7/02

(54) **Electrical junction box to be mounted on a motor vehicle**
Elektroanschlusskasten zur Montage auf einem Kraftfahrzeug
Boîte de raccordement électrique à assembler sur un véhicule à moteur

(30) Priority: 26.10.2007 JP 2007279539
(43) Date of publication of application: 06.05.2009
(73) Proprietor: Sumitomo Wiring Systems, Ltd., Yokkaichi-city, Mie 510-8503 (JP)
(72) Inventor: Kanazawa, Masashi, Yokkaichi-city, Mie Aichi 510-8503 (JP); Sekido, Toshihisa, Yokkaichi-city, Mie Aichi 510-8503 (JP); Higuchi, Eiji, Yokkaichi-city, Mie Aichi 510-8503 (JP)
(74) Representative: Winter, Brandl, Fürniss, Hübner, Röss, Kaiser, Polte - Partnerschaft

(56) References cited:
- EP-A- 1 107 278

## Description

### [Technical Field]

This invention relates to an electrical junction box to be mounted on a motor vehicle and more particularly relates to an electrical junction box to be mounted on a motor vehicle in which a dead space is reduced by decreasing a space required for maintenance such as fuse exchange and a space for attaching the electrical junction box to a vehicle body side can be effectively utilized.

### [Background Art]

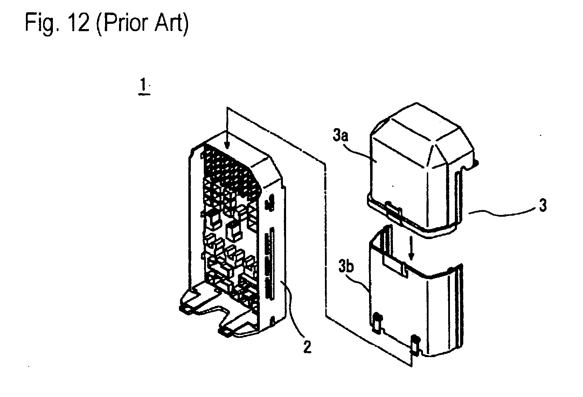

As shown in Fig. 12 of the attached drawings, a conventional electrical junction box 1 to be mounted on a motor vehicle includes a casing body 2. Electrical components such as fuses and relays are detachably mounted on a surface of the casing body 2. A cover 3 is mounted on the casing body 2 to protect the surface to which the electrical components are attached. In JP 2000-316220 A, in compliance with requirement for maintenance such as fuse exchange, the cover 3 is divided into an upper half member 3a and a lower half member 3b. The upper half member 3a covers an area on which electrical components such as fuses accompanied with a high frequency in exchange are mounted. The lower half member 3b covers an area on which electrical components such as relays accompanied with a low frequency in exchange are mounted. Only the upper half member 3a is slid upward and removed from the casing body 2 to carry out fuse exchange.

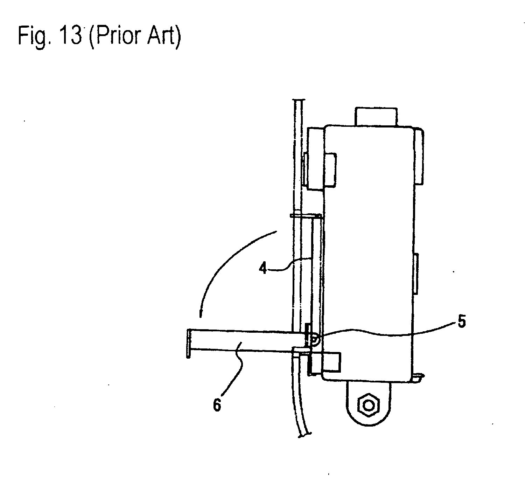

In JUM HEI 5 (1993)-31088 A, as shown in Fig. 13 of the attached drawings, a cover 6 is rotatably connected through a hinge 5 to a fuse box body 4. By rotating the cover 6 in a direction shown by an arrow upon maintenance, fuses mounted on the fuse box body 4 can be exchanged.

However, in order to exchange the fuses, the upper half member 3a must be slid upward in JP 2000-316220 A while the cover 6 must be rotated around the hinge 5 in JUM HEI 5 (1993)-31088 A. These structures require a sliding or rotating space outside the casing body or the fuse box body. Such space becomes a dead space where other components cannot be disposed. This will raise a problem that a space on the vehicle body side cannot be effectively utilized.

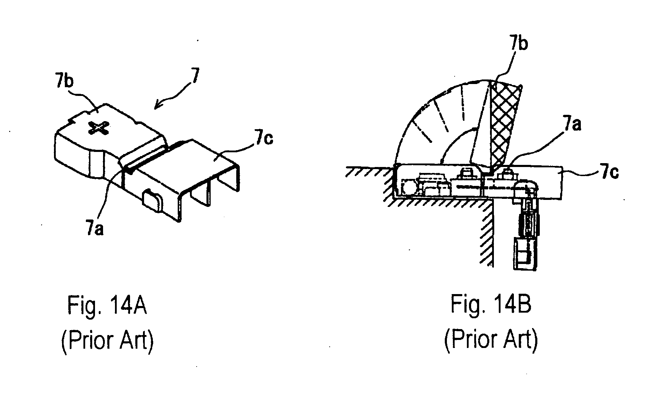

JP 2002-289171 Ahas proposed a structure that can limit a rotary range of a hinged cover. According to Figures 14A and 14B of the attached drawings, there is disclosed a hinged battery cover 7. In the hinged battery cover 7, a rotatable cover member 7b is connected through a hinge portion 7a to a stationary cover member 7c and the hinge portion 7a is disposed at a position lower than the members 7b and 7c. As shown in Fig. 14B, the rotary range of the rotatable cover member 7b is minimized.

However, even if such structure is adopted, a portion shown by cross-hatchings in Fig. 14B is inclined toward the stationary cover member 7c. If any component is disposed on the stationary cover member 7c, the component will interfere with the rotatable cover member 7b. Consequently, if any component must be disposed on the stationary cover member 7c, the component must be disposed at a position separated away from the hinge portion 7a. This will increase an area of the cover member 7c, thereby upsizing the battery cover 7.

Finally EP 1107278 discloses an electrical connector housing as referred to in the preamble of claim 1 which requires a significant dead space in order to operate the maintenance cover.

Furthermore, as disclosed in the above Documents, the cover can be easily opened or removed from the fuse mounting sections provided on the electrical junction box in order to exchange the fuses.

Usually, in order to afford general versatility to the electrical junction box, cavities in the fuse mounting sections are formed in accordance with the maximum units, including the cases required by options. Consequently, there may be blank cavities (disused cavities) on which the fuses are not mounted. For example, even if ten cavities are provided in the fuse mounting sections, the fuses are mounted in seven cavities and the other three cavities become the blank cavities in which fuses are not mounted.

At that time, even if the fuses are not mounted in the blank cavities, there is a case where connecting terminals to be connected to the fuses must be contained in and secured to the blank cavities. That is, in the case where the connecting terminals to be connected to the fuses are made of bus bars with projecting tabs, in order not to contain the connecting terminals in the three blank cavities that should not be connected to the fuses, it may be possible to prepare the bus bars projecting seven tabs to be connected to only seven fuses. However, it is necessary to prepare two kinds of bus bars, namely the bus bars with seven tabs and the bus bars with ten tabs to be connected to ten fuses. This will not be preferable because a component count will increase. Accordingly, in spite of the number of fuses to be connected, the connecting terminals provided with the tabs corresponding to the number of the cavities must be contained in and secured to the fuse mounting sections.

Also, in the case where connecting terminals to be connected to fuses are solderless terminals attached to distal ends of electrical wires, it may be possible to contain the solderless terminals in the three blank cavities. However, for example, in the case of cavities provided with resin lances for engaging the solderless terminals, there is a possibility that different terminals or the like are forcedly contained in and secured to the cavities for the sake of unauthorized use or the like.

Thus, in spite of existence of the disused blank cavities, if the connecting terminals exist, the terminals in the disused blank cavities are exposed when the cover is opened. Consequently, it is not possible to prevent the unauthorized use that pins or the like are inserted into the blank cavities and conducted to the bus bars in the electrical junction box.

Accordingly, if the disused blank cavities are exposed through the opening upon maintenance, there is a problem that the unauthorized use may be induced. It has been required for to overcome this problem.

### [Problems that the Invention is to solve]

In view of the above problems, a first object of the present invention is to provide an electrical junction box to be mounted on a motor vehicle that improves an attaching structure of a maintenance cover that is opened upon maintenance such as fuse exchange, minimizes a space required for maintenance so as to reduce a dead space, and enlarges a space for disposing other components. Moreover, it is aim of the present invention to provide an electrical junction box to be mounted on a motor vehicle in which disused blank cavities in fuse mounting sections are not exposed when a maintenance cover is opened, thereby preventing unauthorized use.

### [Means for Solving the Problems]

In order to achieve the above objects, the present invention provides an electrical junction box to be mounted on a motor vehicle as defined in claim 1.

As described above, since the casing body is provided with the maintenance area for fuse exchange that are concentrically provided with the fuse mounting sections and the maintenance cover to be mounted on the maintenance area is separated from the cover body, it is possible to carry out fuse exchange merely by removing the maintenance cover from the cover body.

In particular, in the present invention, the maintenance cover can be detached upward and straightly from the cover body and can be attached downward from the upper position to the cover body. The locking frames and locking pawls are detachably coupled to one another. The operating portion of each locking frame projects from the peripheral wall outer surface of the maintenance cover. Accordingly, when a working person operates the operating portions to deflect the locking frames, the locking frames on the maintenance cover can be readily coupled to and decoupled from the locking pawls on the casing body. The maintenance cover can be attached to and detached from the casing body in the fuse mounting direction.

Since the space for attaching and detaching the maintenance cover to and from the casing body can be minimized, it is possible to dispose other components on the area that has been the dead space in the prior art and it is also possible to arrange the electrical junction box near the vehicle body, thereby effectively utilizing the space in the vehicle body side.

That is, since the maintenance cover of the present invention is not the conventional type cover disclosed in JUM HEI 5 (1993)-31088 A or JP 2002-289171 Aon EP 1 107 278, the component mounting area is not reduced on account of interference with the cover, thereby accomplishing the object of the present invention.

Preferably, a pair of locking frames is provided on the peripheral wall of the maintenance cover. Particularly, the pair of locking frames is preferably separated away from each other by a distance that a working person can hold the pair of locking frames by one hand.

Preferably, the locking pawls on the cover body project from the inner surface of the through-holes opened in the surface of the cover body, and locking frames on the maintenance cover are inserted into the through-holes to engage the locking pawls.

As described above, by projecting the locking pawl from the inner surface of each through-hole opened in the surface of the cover body without projecting the locking pawl from the peripheral wall outer surface of the cover body, coupling and decoupling the locking pawl and lower frame member of the locking frame to and from each other are carried out in each through-hole and it is not necessary to reserve a space for effecting the above action on the outside of the electrical junction box, thereby more effectively utilizing a space in the vehicle body side. It is also possible to couple and decouple the locking pawl and lower frame member to and from each other without interfering with peripheral components or the like, thereby enhancing workability.

The through-holes are not limited so long as the through-holes are provided on the inner surfaces with the locking pawls and have spaces in which the locking frames are engaged with and disengaged from the locking pawls while deflecting the locking frames in the through-holes. For example, it is preferable that the sides provided with the locking pawls are opposed to each other and a pair of rectangular through-holes is formed to receive the locking frames.

Preferably, a plurality of narrow locking pawls or a single wide locking pawl project or projects from the inner surface of each through-hole in order to enhance a coupling force between the locking frame and the locking pawl. For example, if two narrow locking pawls may be provided on one through-hole while one wide locking pawl may be provided on the other through-hole, it is possible to enhance the coupling force between the locking frame and the locking pawl while preventing a misalignment of the maintenance cover.

Preferably, each of the locking frames provided on the maintenance cover includes hinge portions and a rectangular frame portion having right and left frame members, an upper frame member, and a lower frame member. The rectangular frame portion is attached through the hinge portions to the peripheral wall outer surface. The upper frame member is connected to the right and left frame members so as to serve as an operating portion. Each of the lower frame members is adapted to engage each of the locking pawls.

According to the above construction, when the operating portion of each locking frame is pushed inward, the lower frame member of each locking frame is deflected outward around the hinge portions coupling the right and left frame members of each locking frame to the peripheral wall outer surface of the maintenance cover. Accordingly, in order to couple the maintenance cover to the cover body, the lower frame member of each locking frame is inserted into each through-hole in the cover body while pushing inward the operating portion of each locking frame of the maintenance cover, the deflected lower frame member surmounts the locking pawl on the inner surface of the through-hole, and then the lower frame member is engaged with the locking pawl by an elastic recovery force of the operating portion when the operating portion is released.

On the other hand, when the maintenance cover is removed from the cover body, the operating portion of each locking frame is pushed inward, the lower frame member of each locking frame that has been engaged with the locking pawl is deflected outward. The lower frame member is drawn upward from the through-hole to release engagement with the locking pawl.

Preferably, the stopper protrusions are provided on the upper wall of the maintenance cover at the position corresponding to the right and left frame members of each locking frame so as to limit the deflection angle of each locking frame.

When the operating portion of the locking frame is pushed inward, the lower frame member of each locking frame is deflected outward, and the hinge portions that serve as fulcrum axes will be subject to a torsion force (shearing force). Accordingly, by providing the stopper protrusions on the upper wall of the maintenance cover, the right and left frame members of the locking frame collide against the stopper protrusions when the lock frame is deflected by a large amount. Consequently, it is possible to prevent the locking frame from being excessively deflected and to prevent the hinge portions from being broken.

Preferably, the maintenance area adjoins to an outer end edge of the casing body. A peripheral wall and an upper wall of the cover body are cut off at positions corresponding to the maintenance area. The maintenance cover is mounted on the cut-off portions of the walls. The cut-off portion of the peripheral wall of the cover body is continued to an outer peripheral wall of the maintenance cover. A pair of opposed side walls is provided on longitudinal opposite ends of the outer peripheral wall. Each of the opposed side walls is provided with each of the locking frames. The opposed side walls are disposed inside the peripheral wall of the cover body, and each of the locking frames is engaged with each of the locking pawls projecting from inner surfaces of the through-holes in the cover body.

As described above, since the peripheral wall of the cover body that corresponds to the maintenance area adjacent the outer edge end of the casing body is cut off and the cut-off portion continues to the outer peripheral wall contiguous to the upper wall of the maintenance cover, it is possible to enhance strength of the peripheral wall more than that of a structure in which a thin plate-like peripheral wall of the cover body is not cut off and only the cut-off upper wall is covered with the maintenance cover.

Since each of the pair of opposed side walls is provided with the locking frame that continues to the longitudinal opposite ends of the outer peripheral wall of the maintenance cover and the opposed side walls are disposed inside the peripheral wall of the cover body, it is possible to prevent the operating portion of each locking frame from projecting outward from the electrical junction box and a working person can easily operate the operating portion without touching the peripheral components and couple and decouple the maintenance cover to and from the casing body.

In the present invention, the fuse mounting sections are formed in the maintenance area opened and closed by the maintenance cover. The fuse mounting sections are provided with cavities in the case where the fuses are attached to the sections while the sections are not provided with the cavities in the case where the fuses are not attached to the sections. The portions in which the cavities are not provided are defined as the additional fuse mounting area. The additional fuse mounting area is provided with means for preventing unauthorized access.

The flat portions and/or grid-like frame portions are provided as preventing means for unauthorized access.

In more detail, in the case where any fuse is added by options, in preparation for the case where the fuse is added to a high grade motor vehicle in the same kind of motor vehicle, the additional fuse mounting area is provided on the maintenance area that is opened when the maintenance cover is removed.

That is, only the grid-like frame portions are previously provided on the additional fuse mounting area to section the portions adapted to be the cavities to mount the additional fuses but terminal engaging protrusions or the like are not provided on the additional fuse mounting area. It is further preferable to provide the closing portions above the grid-like frame portions.

According to the above structure, any terminal for unauthorized use cannot be inserted into the additional fuse mounting area. Since the portions to be formed into cavities for additional fuses are previously sectioned, in the case where additional cavities should be formed, only the portions surrounded by the grid-like frames are altered.

Also, in the case where any additional cavities should be formed in the flat portions, only the flat portions are altered.

According to the above construction, even if the fuses are not mounted on the additional fuse mounting area, the connecting terminals are not exposed through the opening in the maintenance area, and the bus bars or the like in the electrical junction box cannot be conducted by inserting different connecting terminals into the regular connecting terminals, or by inserting any pins or the like into the terminals contained in the fuse mounting sections.

Also, in the case of adding any fuses, only cavities for additional fuses in a mold for forming the casing body are altered. This will minimize the alteration of the mold and costs in production.

### [Effects of the Invention]

As described above, according to the present invention, since the casing body is provided with the maintenance area for fuse exchange that are concentrically provided with the fuse mounting sections and the maintenance cover to be mounted on the maintenance area is separated from the cover body, it is possible to carry out fuse exchange merely by removing the maintenance cover from the cover body.

In particular, in the present invention, the maintenance cover can be detachably coupled to the cover body by engagement of the locking frames and the locking pawls and the operating portion of each locking frame projects from the peripheral wall outer surface of the maintenance cover. Accordingly, when a working person operates the operating portions to deflect the locking frames to adjust the deflection angle of each locking frame, the locking frames on the maintenance cover can be readily released from the locking pawls on the casing body. The maintenance cover can be attached to and detached from the casing body in the fuse mounting direction. Accordingly, since the space for attaching and detaching the maintenance cover to and from the casing body can be minimized, it is possible to dispose other components on the area that has been the dead space in the prior art and it is also possible to arrange the electrical junction box near the vehicle body, thereby effectively utilizing the space in the vehicle body side.

As described above, by projecting the locking pawl from the inner surface of each through-hole opened in the surface of the cover body without projecting the locking pawl from the peripheral wall outer surface of the cover body, coupling and decoupling the locking pawl and lower frame member of each locking frame to and from each other are carried out in the through-hole and it is not necessary to reserve a space for effecting the above action on the outside of the electrical junction box, thereby more effectively utilizing a space in the vehicle body side. It is also possible to couple and decouple the locking pawl and lower frame member to and from each other without interfering with peripheral components or the like, thereby enhancing workability.

Furthermore, since the closing portion and/or the grid-like frame portions are provided on the maintenance area that are exposed outside when the maintenance cover is removed upon maintenance or the fuse mounting sections in which the connecting terminals are contained and fixed, it is possible to prevent other terminals or pins from being forcedly inserted into the fuse mounting sections to conduct the circuits such as bus bars in the electrical junction box, thereby surely preventing unauthorized use.

### [Brief Explanation of the Drawings]

Figure 1 is an exploded perspective view of an embodiment of an electrical junction box to be mounted on a motor vehicle in accordance with the present invention.
Figure 2A is a side elevation view of an upper cover of the electrical junction box.
Figure 2B is a side elevation view of a casing body of the electrical junction box.
Figure 2C is a side elevation view of a lower cover of the electrical junction box.
Figure 3 is a side elevation view of the electrical junction box to be mounted on a motor vehicle in accordance with the present invention.
Figure 4A is a plan view of the casing body.
Figures 4B and 4C are sectional view of main parts of the casing body.
Figure 5 is a plan view of the cover body.
Figure 6 is a plan view of the cover body, illustrating the cover body mounted on the casing body.
Figure 7 is a plan view of a maintenance cover, illustrating the maintenance cover mounted on a maintenance area on the casing body shown in Fig. 6.
Figure 8A is a schematic perspective view of the maintenance cover.
Figure 8B is a schematic perspective view of the cover body.
Figure 9 is an enlarged view of a main part of a locking frame of the cover body.
Figure 10A is a perspective view of the locking frame, illustrating a lower frame member of the locking frame immediately before being engaged with a locking pawl of the cover body.
Figure 10B is a perspective view of the locking frame, illustrating the lower frame member of the locking frame after being engaged with the locking pawl of the cover body.
Figures 11A and 11B are sectional views similar to Fig. 4C, illustrating alterations of the main parts of the casing body.
Figure 12 is an exploded perspective view of a prior art electrical junction box to be mounted on a motor vehicle.
Figure 13 is a side elevation view of another prior art electrical junction box.
Figure 14A is a perspective view of a prior art battery cover.
Figure 14B is a side elevation view of the battery cover, illustrating a rotary range of the battery cover.

### [Preferred Aspects of Embodying the Invention]

Referring now to the drawings, embodiments of an electrical junction box to be mounted on a motor vehicle in accordance with the present invention will be described below.

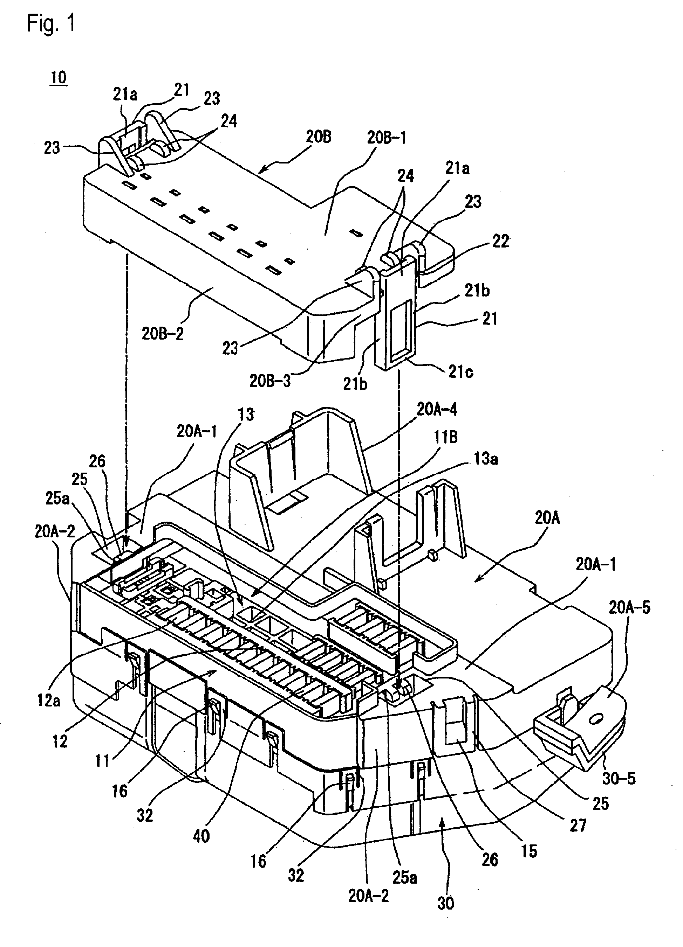

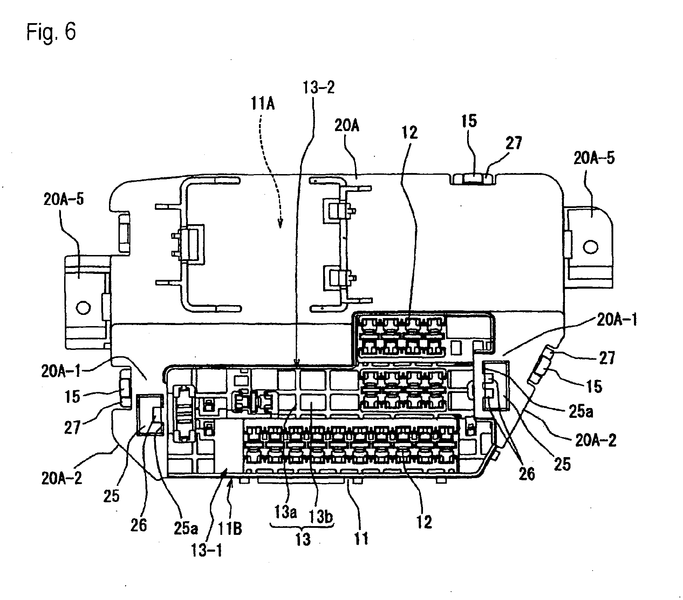

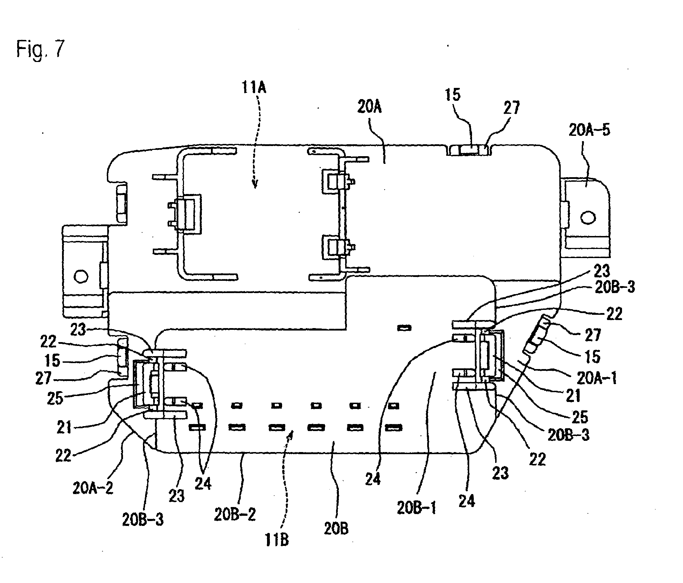

Figures 1 to 10 show an embodiment of an electrical junction box to be mounted on a motor vehicle in accordance with the present invention.

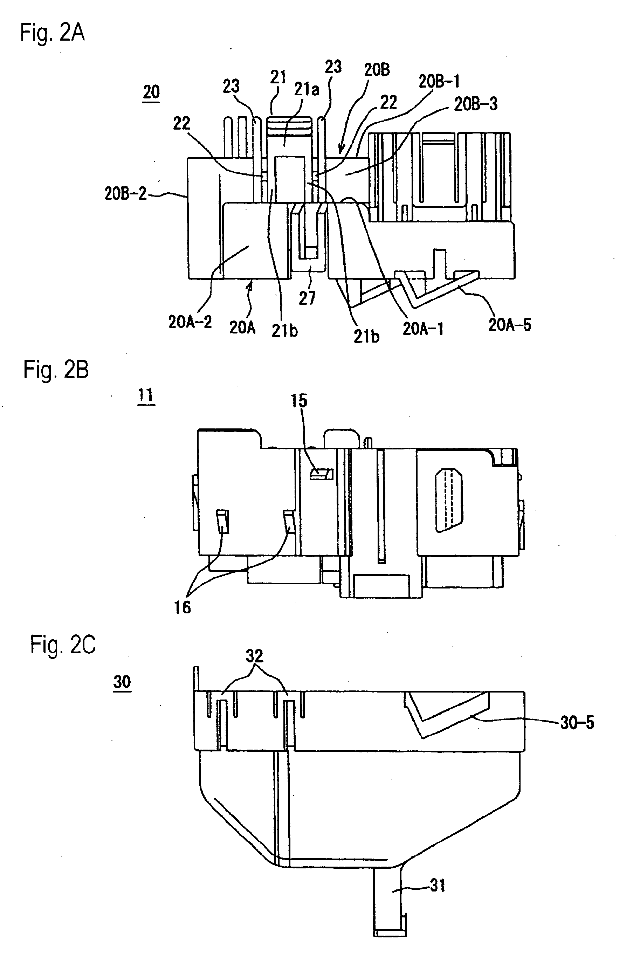

As shown in Fig. 2, an electrical junction box 10 to be mounted on a motor vehicle in accordance with the present invention includes a casing body 11, an upper cover 20 to be mounted on an upper part of the casing body 11, and a lower cover 30 to be mounted on a lower part of the casing body 11.

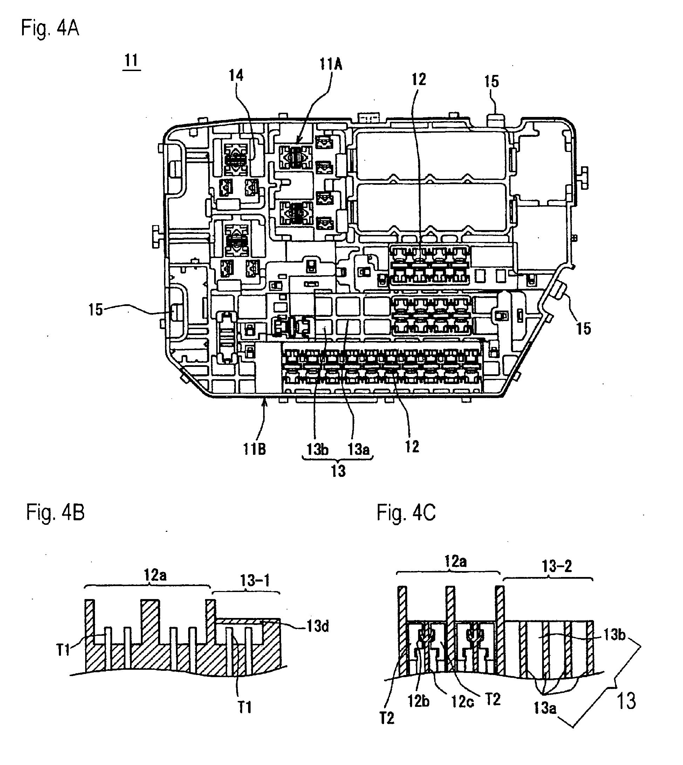

The casing body 11 contains bus bars (not shown) that are interior circuit members. As shown in Fig. 4A, the casing body 11 is provided on an outer edge end with a maintenance area 11B for fuse exchange. Fuse mounting sections 12 are provided on the maintenance area 11B. The fuse mounting sections 12 contain and secure bus bars with tab terminals T1 (Fig. 4B) projecting from a lower surface of the casing body 11 to be connected to the fuses, and solderless or insulation displacement terminals T2 (Fig. 4C) to be connected to distal ends of electrical wires.

In the case where fuses are connected to the tab terminals T1, the casing body 11 is provided on a top surface with cavities 12a, as shown in Fig. 4B. In the case where fuses are not connected to the tab terminals T1, the casing body 11 is not provided with the cavities 12a but is provided with a flat portion 13d to cover the tab terminals T1. This constitutes a structure for preventing an authorized conduction of the tab terminals T1. This portion is defined as an additional fuse mounting area 13-1.

In the case where fuses are connected to the solderless terminals T2, the casing body 11 is provided on a top surface with cavities 12a, as shown in Fig. 4C. The cavities 12a are provided with partitions 12c having lances 12b to contain and engage the solderless terminals T2.

In the case where fuses are not connected to the solderless terminals T2, the casing body 11 is not provided with the cavities 12a but is provided with a grid-like frame 13. The grid-like frame 13 includes a plurality of ribs 13a integrally formed on the casing body 11 and a plurality of hollow sections 13b defined between the ribs 13a. The hollow sections 13b form through-holes. The ribs 13a surrounding the hollow sections 13b are not provided with lances 12b for securing the solderless terminals T2. This constitutes a structure for preventing an authorized accommodation of other terminals. These sections are defined as an additional fuse mounting area 13-2.

Although the bus bars with projecting tab terminals T1 and the solderless terminals T2 are contained in and secured to the fuse mounting sections 12 in the present embodiment, only the bus bars with projecting tab terminals or only the solderless terminals may be contained in and secured to the fuse mounting sections.

Also, an area except the maintenance area 11B on the surface of the casing body 11 is defined as a non-maintenance area 11A in which relay mounting sections 14 are provided.

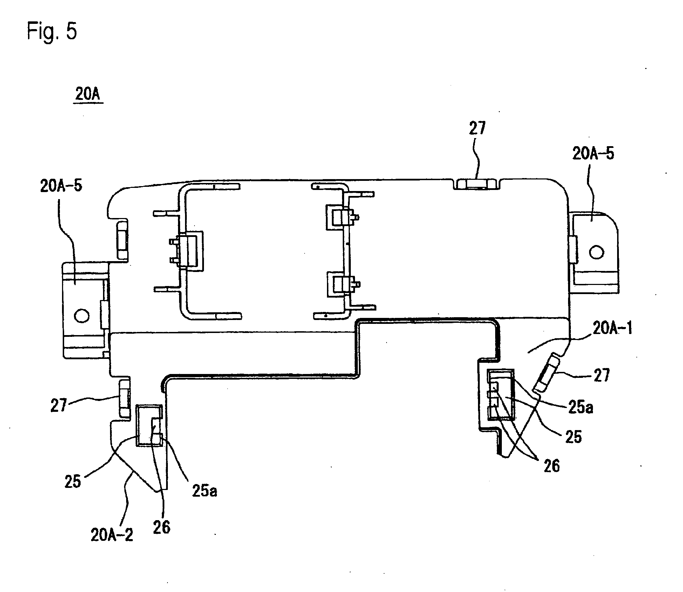

As shown in Figures 5 to 8, the upper cover 20 includes a cover body 20A to be mounted on the non-maintenance area 11A and a maintenance cover 20B to be mounted on the maintenance area 11B. The maintenance cover 20B is separated from the cover body 20A.

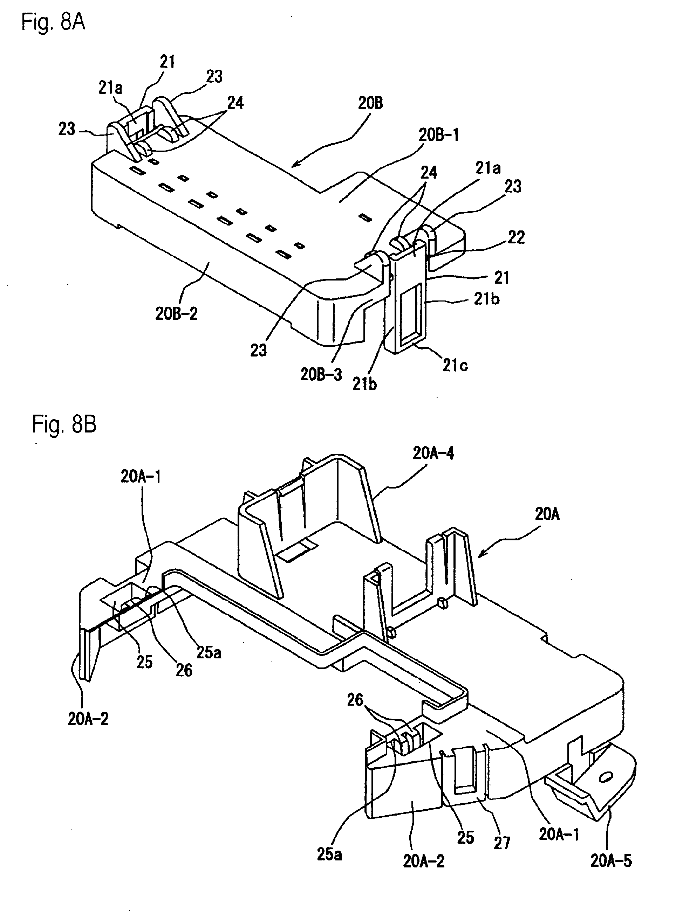

In more detail, an upper wall 20A-1 and a peripheral wall 20A-2 of the cover body 20A to be mounted on the non-maintenance area 11 A are cut off at positions corresponding to the maintenance area 11B. An electronic unit mounting section 20A-4 (Fig. 8B) projects from the surface of the cover body 20A adjacent an end edge that is cut off to define the maintenance area 11B.

On the other hand, the maintenance cover 20B is disposed on the cut-off space. The maintenance cover 20B is formed so that an outer peripheral wall 20B-2 continues to the cut-off portion in a peripheral wall 20A-2 of the cover body 20A upon disposing the maintenance cover 20B.

A pair of opposed side walls 20B-3 are continued to longitudinal opposite ends of an outer peripheral walls 20B-2 of the maintenance cover 20B. A flexible locking frame 21 is provided on an outer surface of each opposed side wall 20B-3.

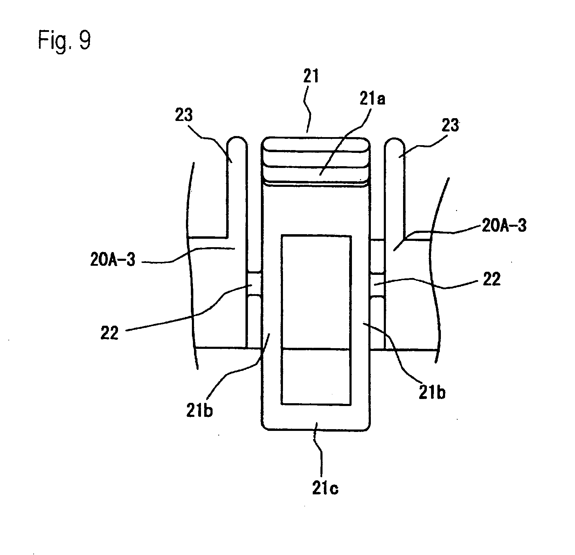

The locking frame 21 is formed into a rectangular configuration shown in Fig. 8A and Fig. 9. Right and left frame members 21 b of the rectangular locking frame 21 are attached through hinge portions 22 to an outer surface of each opposed side wall 20B-3. An upper frame member 21 a of the rectangular locking frame 21 serves as an operating portion for adjusting a deflection angle of the locking frame 21. A lower frame member 21 c of the rectangular locking frame 21 serves as a locking portion for engaging locking pawls 26 described after. A pair of ribs 23 projects from an upper wall 20B-1 of the maintenance cover 20B so that the ribs 23 interpose the right and left frame members 21 b. A pair of stopper protrusions 24 projects from the upper wall 20B-1 of the maintenance cover 20B at positions opposed to the right and left frame members 21b between the ribs 23 to limit a deflection angle of the locking frame 21.

On the other hand, as shown in Fig. 8B, the cover body 20A is provided with a pair of rectangular through-holes 25 into which the pair of locking frames 21 of the maintenance cover 20B are inserted. Each rectangular through-hole 25 is provided on a long side inner surface 25a with locking pawls 26 that the lower frame member 21 c of each locking frame 21 engages. In the present embodiment, two locking pawls 26 are provided on one through-hole 25 while a single wide pawl 26 is provided on the other through-hole 25.

Vehicle body attaching brackets 20A-5 are provided on a peripheral wall 20A-2 of the cover body 20A. Vehicle body attaching brackets 30-5 are provided on the lower cover 30 to be mounted on the brackets 20A-5. The brackets 20A-5 are superimposed on the brackets 30-5, bolts are inserted into bolt holes in the brackets, and the cover body 20A and lower cover 30 are attached to vehicle body attaching members (not shown).

The cover body 20A constituting the upper cover 20 and the lower cover 30 are provided on their peripheral walls with engaging frame portions 27 and 32 while the casing body 11 is provided on a peripheral wall outer surface with engaging pawls 15. By locking the engaging pawls 15 on the engaging frame portions 27 and 32, the casing body 11 is enclosed in the cover body 20A and lower cover 30.

The maintenance cover 20B is connected to an upper end surface of the lower cover 30 at a lower end of a peripheral wall of the cut-off portion of the cover body 20A.

Next, steps for assembling the electrical junction box 10 to be mounted on a motor vehicle in accordance with the present invention will be described below.

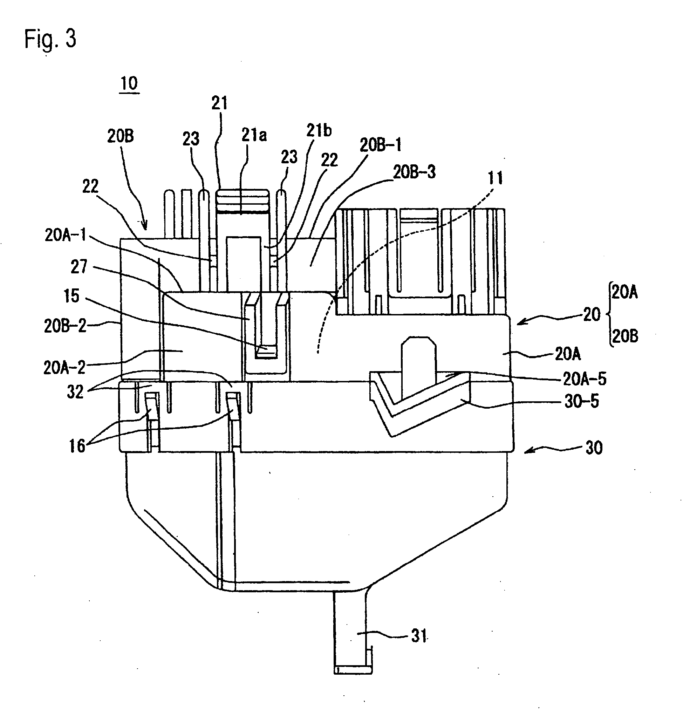

Fuses 40 and relays (not shown) are mounted on the fuse-mounting sections 12 and relay mounting sections14 of the casing body 11. After a wire harness (not shown) is drawn through a wire harness inserting portion 31 into the casing body 11 and is connected to the interior circuit members in the casing body 11, the upper cover 20 and lower cover 30 are assembled on the casing body 11 to form the electrical junction box 10 (see Fig. 3).

Although the maintenance cover 20B is coupled to the cover body 20A after the cover body 20A and lower cover 30 are assembled on the casing body 11, in the present embodiment, after the maintenance cover 20B is previously coupled to the cover body 20A, the cover body 20A may be assembled on the casing body 11.

Assembling of the cover body 20A and casing body 11 is carried out by locking the engaging pawls 15 on the peripheral wall of the casing body 11 onto the engaging frame portions 27 on the peripheral wall 20A-2 of the cover body 20A. Assembling the lower cover 30 and casing body 11 is carried out by locking the engaging pawls 16 on the peripheral wall of the casing body 11 onto the engaging frame portions 32 on the peripheral wall of the lower cover 30.

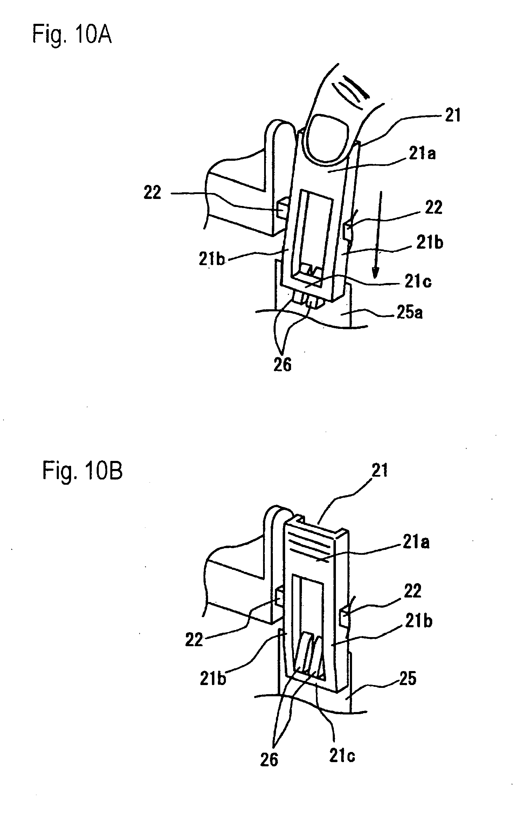

The maintenance cover 20B is coupled to the cover body 20A firstly by inserting the lower frame member 21 c of each locking frame 21 into each through-hole 25 in the cover body 20A while pushing inward the operating portion 21 a of each locking frame 21 of the maintenance cover 20B, secondly by releasing the operating portion 21a when the lower frame member 21c deflected outward around the hinge portion 22 surmounts the locking pawl 26 on the inner surface 25a of the through-hole, finally by locking the lower frame member 21 c onto the lower and of the locking pawl 26 by an elastic recovery force of the operating portion 21a (see Fig. 10). Thus, the maintenance cover 20B is detachably coupled to the cover body 20A. Under this coupling condition, the opposed side walls 20B-3 of the maintenance cover 20B are disposed inside the peripheral wall 20A-2 of the cover body 20A and the outer peripheral wall 20B-2 of the maintenance cover 20B continues to the cut-off portion of the peripheral wall 20A-2 of the cover body 20A.

When any fuse must be exchanged, the lower frame member 21 c of each locking frame 21 that is engaged with the locking pawl 26 is deflected outward by pushing inward the operating portion 21a of the locking frame 21 and the lower frame member 21c is released from the locking pawl 26 by drawing the lower frame member 21 c from the through-hole 25 while keeping the deflection of the member 21c. Thus, the maintenance cover 20B can be removed from the cover body 20A in a fuse mounting direction.

As described above, since the casing body 11 is provided with the maintenance area 11B for fuse exchange and the maintenance cover 20B to be mounted on the maintenance area 11B is separated from the cover body 20A, it is possible to readily exchange any fuse merely by detaching only the maintenance cover 20B from the casing body 11.

In particular, since the maintenance cover 20B and cover body 20A are detachably coupled to each other by engaging the locking pawl 26 with the lower frame member 21 c and the operating portion 21 a of the locking frame 21 projects over the peripheral wall outer surface 20B-2 of the maintenance cover 20B, a working person can easily couple and decouple the locking pawl 26 on the cover body 20A and the lower frame member 21 c of the locking frame 21 to and from each other by adjusting the deflection angle of the locking frame 21. Thus, it is possible to connect and disconnect the maintenance cover 20B to and from the casing body 11 in the fuse mounting direction. Accordingly, since it is possible to minimize a space required for coupling and decoupling the maintenance cover 20B, namely to minimize it down to the space which is the necessary one for inserting or removing fuses and which as such is the minimum necessary one, other components can be disposed on a portion that has been a dead space in the prior art and the electrical junction box can be disposed near the vehicle body frame. Consequently, a space in the vehicle body side can be effectively utilized.

As described above, by projecting the locking pawl 26 from the inner surface 25a of the through-hole 25 opened in the surface of the cover body 20A without projecting the locking pawl 26 from the peripheral wall outer surface 20A-2 of the cover body 20A, coupling and decoupling the locking pawl 26 and lower frame member 21c of the locking frame 21 to and from each other are carried out in the through-hole 25 and it is not necessary to reserve a space for effecting the above action on the outside of the electrical junction box 10. Accordingly, it is possible to provide the electronic unit mounting section 20A-4 on the cover body 20A near the maintenance cover 20B, thereby more effectively utilizing a space.

It is also possible to couple and decouple the locking pawl and lower frame member 21 c to and from each other without interfering with peripheral components or the like, thereby enhancing workability.

Furthermore, as described above, by providing the stopper protrusions 24 on the upper wall 20B-1 of the maintenance cover 20B, the right and left frame members 21 b collide against the stopper protrusions 24 when the lock frame 21 is deflected greatly. Consequently, it is possible to prevent the locking frame 21 from being excessively deflected and to prevent the hinge portions 22 from being broken.

As described above, since the additional fuse mounting areas 13-1 and 13-2 are not provided with the cavity 12a but they are provided with the closing flat portion or a grid-like frame portion 13, other terminals or pins cannot be inserted into or secured to any additional fuse mounting areas, even if an unauthorized person intends to insert other terminals or pins into any additional fuse mounting areas. These structures can prevent unauthorized use.

By previously providing the additional fuse mounting areas 13-1 and 13-2 on the casing body 11, in the case where an additional fuse must be mounted on the casing body 11 due to alteration in specifications or the like, it is possible to minimize alteration of a mold, thereby restrain a cost in production.

Furthermore, since the brackets 20A-5 of the cover body 20B that constitutes the upper cover 20 are superimposed on the brackets 30-5 of the lower cover 30 and they are attached to the vehicle body by the bolts, the casing body 11 cannot be removed from the upper cover 20 and lower cover 30 unless the bolts are removed from the brackets. Accordingly, it is possible to prevent unauthorized access to the non-maintenance area 11A.

Thus, the electrical junction box of the present invention also has an effective countermeasure for unauthorized access.

As described above, since the peripheral wall 20A-2 of the cover body 20A that corresponds to the maintenance area 11 B adjacent the outer edge end of the casing body 11 is cut off and the cut-off portion continues to the outer peripheral wall 20B-2 contiguous to the upper wall 20B-1 of the maintenance cover 20B, it is possible to enhance strength of the peripheral wall more than that of a structure in which a thin plate-like peripheral wall of the cover body is not cut off and only the cut-off upper wall is covered with the maintenance cover.

Since each of the pair of opposed side walls 20B-3 is provided with the locking frame 21 that continues to the longitudinal opposite ends of the outer peripheral wall 20B-2 of the maintenance cover 20B and the opposed side walls 20B-3 are disposed inside the peripheral wall 20A-2 of the cover body 20A, it is possible to prevent the operating portion 21 a of each locking frame 21 from projecting outward from the electrical junction box 10 and a working person can easily operate the operating portion 21 a without touching the peripheral components and couple and decouple the maintenance cover 20B to and from the casing body 11.

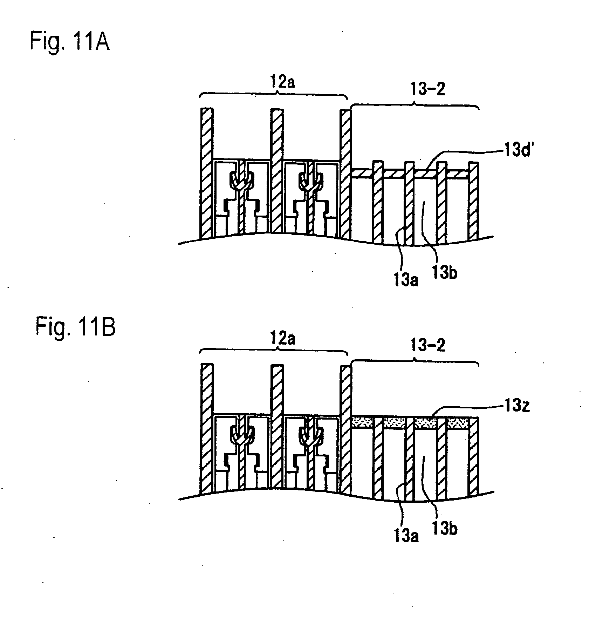

The present invention is not limited to the above embodiment. The additional fuse mounting area 13-1 to be closed by the maintenance cover 20B is integrated with a closing flat portion 13d' bridging the ribs 13a, as shown in Fig. 11A. Thus, since the flat portion 13d' closes the hollow portions 13b, it is possible to surely prevent unauthorized access to the casing body 11 through the hollow portion 13b.

Also, as shown in Fig. 11B, individual closing plugs 13z are inserted into and secured to the hollow portions 13b to bride the ribs. In this case, if any fuse must be added, a cavity may be merely provided instead of the closing plug 13z. Accordingly, it is not necessary to reform the casing body 11. This will enhance general versatility and can prevent unauthorized use.

### [Explanation of Signs]

- 10: electrical junction box
- 11: casing body
- 11A: non-maintenance area
- 11B: maintenance area
- 12: fuse mounting sections
- 13-1, 13-2: additional fuse mounting areas
- 14: relay mounting sections
- 20: upper cover
- 20A: cover body
- 20A-1: upper wall
- 20A-2: peripheral wall
- 25: through-holes
- 25a: inner surface
- 26: locking pawls
- 20B: maintenance cover
- 20B-1: upper wall
- 20B-2: outer peripheral wall
- 20B-3: opposed side walls
- 21: locking frames
- 21 a: operating portions
- 21b: right and left frame members
- 22: hinge portions
- 23: ribs
- 24: stopper protrusions
- 30: lower cover

## Claims

1. An electrical junction box (10) to be mounted on a motor vehicle, including:
a casing body (11) provided concentrically on a surface with a plurality of fuse mounting sections (12) in a maintenance area (11 B) for exchanging fuses to be attached to said fuse mounting sections (12);
a cover body (20A) mounted on and coupled to said casing body (11) at a non-maintenance area (11A) except said maintenance area (11 B) on said casing body (11); and
a maintenance cover (20B) separated from said cover body (20A) and mounted on said maintenance area (11B) on said casing body (11); wherein
said maintenance cover (20B) is provided on a peripheral wall outer surface (20B-2) with flexible locking frames (21), an operating portion (21 a) projecting from each of said locking frames (21);
a locking pawl (26) is provided on said cover body (20A) at a position corresponding to each of said locking frames (21); and
said maintenance cover (20B) is detachably coupled to said locking pawls (26) while deflecting said locking frames (21); **characterised in that** said operating portion (21a) also project over said peripheral wall outer surface (20B-2) of said maintenance cover (20B).

2. An electrical junction box (10) according to Claim 1, wherein each of said locking pawls (26) provided on said cover body (20A) projects from an inner surface of a respective through-hole (25) opened in a surface of said cover body (20A), and said locking frames (21) of said maintenance cover (20B) are respectively inserted into said through-holes (25) to engage each of said locking pawls (26).

3. An electrical junction box (10) according to Claim 1 or 2, wherein each of said locking frames (21) provided on said maintenance cover (20B) includes hinge portions (22) and a rectangular frame portion having right and left frame members (21 b), an upper frame member (21 a), and a lower frame member (21 c), said rectangular frame portion being attached through said hinge portions (22) to said peripheral wall outer surface (20B-2), said upper frame member (21 a) being connected to said right and left frame members (21 b) so as to serve as an operating portion (21 a), and said lower frame member being adapted to engage a respective locking pawl (26).

4. An electrical junction box (10) according to any one of Claims 1 to 3, wherein said fuse mounting sections (12) formed on said maintenance area (11 B) are closed and opened by said maintenance cover (20B), said fuse mounting sections (12) are provided with cavities (12a) in the case where fuses are attached to said sections (12) and are not provided with said cavities in the case where fuses are not attached to said sections (12), these portions having no cavities serve as an additional fuse mounting area (13-1, 13-2), and said additional fuse mounting area is adapted to be covered with an access-preventing flat portion (13d).

5. An electrical junction box (10) according to any one of Claims 2 to 4, wherein said maintenance area (11 B) adjoins to an outer end edge of said casing body (11);
wherein a peripheral wall and an upper wall of said cover body (20A) are cut off at positions corresponding to said maintenance area (11 B), and said maintenance cover (20B) is mounted on said cut-off portions of said walls;
wherein said cut-off portion of said peripheral wall of said cover body (20A) is continued to an outer peripheral wall of said maintenance cover (20B); and
wherein a pair of opposed side walls (20B-3) is provided on longitudinal opposite ends of said outer peripheral wall, each of said opposed side walls is provided with each of said locking frames (21), said opposed side walls are disposed inside said peripheral) wall of said cover body (20A), and each of said locking frames (21) is engaged with each of said locking pawls (26) projecting from inner surfaces of said through-holes in said cover body (20A).

## Patentansprüche

1. Ein Elektroanschlusskasten (10) zur Montage an einem Kraftfahrzeug, mit:
einem Gehäusekörper (11), der konzentrisch auf einer Oberfläche mit einer Mehrzahl von Sicherungsanbringabschnitten (12) in einem Wartungsbereich (11 B) zum Austausch von Sicherungen versehen ist, die an den Sicherungsanbringabschnitten (12) anzubringen sind;
einem Abdeckungskörper (20A), der an dem Gehäusekörper (11) in einem Nichtwartungsbereich (11A) außerhalb des Wartungsbereichs (11B) an dem Gehäusekörper (11) angeordnet und hiermit verbunden ist; und
einer Wartungsabdeckung (20B) getrennt von dem Abdeckungskörper (20A) und an dem Wartungsbereich (11B) des Gehäusekörpers (11) angeordnet; wobei
die Wartungsabdeckung (20B) an einer Umfangswandaußenfläche (20B-2) mit flexiblen Verriegelungsrahmen (21) versehen ist, wobei ein Betätigungsabschnitt (21a) von jedem der Verriegelungsrahmen (21) vorsteht;
eine Verriegelungsklaue (26) an dem Abdeckungskörper (20A) an einer Position entsprechend eines jeden der Verriegelungsrahmen (21) angeordnet ist; und
die Wartungsabdeckung (20B) lösbar mit den Verriegelungsklauen (26) unter Auslenkung der Verriegelungsrahmen (21) verbunden ist, **dadurch gekennzeichnet, dass**
der Betätigungsabschnitt (21 a) auch über die Umfangswandaußenfläche (20B-2) der Wartungsabdeckung (20B) vorsteht.

2. Ein Elektroanschlusskasten (10) nach Anspruch 1, wobei jede der Verriegelungsklauen (26) an dem Abdeckungskörper (20A) von einer Innenoberfläche einer entsprechenden Durchgangsöffnung (25) vorsteht, die sich in einer Oberfläche des Abdeckungskörpers (20A) öffnet, wobei die Verriegelungsrahmen (21) der Wartungsabdeckung (20B) entsprechend in die Durchgangsöffnungen (25) für einen Eingriff mit jeder der Verriegelungsklauen (26) eingesetzt sind.

3. Ein Elektroanschlusskasten (10) nach Anspruch 1 oder 2, wobei jeder der Verriegelungsrahmen (21) an der Wartungsabdeckung (20B) Scharnierabschnitte (22) und einen rechteckförmigen Rahmenabschnitt mit rechtem und linkem Rahmenteilen (21 b), einem oberen Rahmenteil (21 a) und einem unteren Rahmenteil (21 c) enthält, wobei der rechteckförmige Rahmenabschnitt über die Scharnierabschnitte (22) an der Umfangswandaußenfläche (20B-2) angebracht ist, das obere Rahmenteil (21 a) mit den rechten und linken Rahmenteilen (21b) verbunden ist, um als ein Betätigungsabschnitt (21a) zu dienen und das untere Rahmenteil mit einer entsprechenden Verriegelungsklaue (26) im Eingriff bringbar ist.

4. Ein Elektroanschlusskasten (10) nach einem der Ansprüche 1 bis 3, wobei die Sicherungsanbringabschnitte (12), die in dem Wartungsbereich (11 B) ausgebildet sind, mittels der Wartungsabdeckung (20B) verschließbar und öffenbar sind, wobei die Sicherungsanbringabschnitte (12) mit Hohlräumen (12a) für den Fall versehen sind, dass Sicherungen an den Abschnitten (12) angebracht werden und nicht mit den Hohlräumen für den Fall versehen sind, dass keine Sicherungen an den Abschnitten (12) angebracht werden, wobei diese Abschnitte ohne Hohlräume als ein zusätzlicher Sicherungsanbringbereich (13-1, 13-2) dienen und der zusätzliche Sicherungsanbringbereich mit einem zugriffsverhindernden flachen Abschnitt (13d) verdeckbar ist.

5. Ein Elektroanschlusskasten (10) nach einem der Ansprüche 2 bis 4, wobei der Wartungsbereich (11 B) an eine äußere Endkante des Gehäusekörpers (11) angrenzt;
wobei eine Umfangswand und eine obere Wand des Abdeckungskörpers (20A) an Positionen entsprechend des Wartungsbereichs (11 B) abgeschnitten sind und die Wartungsabdeckung (20B) an den ausgeschnittenen Abschnitten der Wände angeordnet ist;
wobei der ausgeschnittene Abschnitt der Umfangswand des Abdeckungskörpers (20A) zu einer äußeren Umfangswand der Wartungsabdeckung (20B) fortgeführt ist; und
wobei ein Paar von gegenüberliegenden Seitenwänden (20B-3) an in Längsrichtung gegenüberliegenden Enden der äußeren Umfangswand angeordnet ist, wobei jede der gegenüberliegenden Seitenwände mit einem der Verriegelungsrahmen (21) versehen ist, wobei die gegenüberliegenden Seitenwände innerhalb der Umfangswand des Abdeckungskörpers (20A) angeordnet sind und jeder der Verriegelungsrahmen (21) mit jeder der Verriegelungsklauen (26) in Eingriff ist, welche von Innenflächen der Durchgangsöffnungen in dem Abdeckungskörper (20A) vorstehen.

## Revendications

1. Boîte de raccordement électrique (10) à assembler sur un véhicule à moteur, comprenant :
un corps de carter (11) disposé concentriquement sur une surface avec une pluralité de parties de montage de fusibles (12) dans une zone de maintenance (11B) pour échanger des fusibles à attacher aux dites parties de montage de fusibles (12) ;
un corps de couvercle (20A) monté sur ledit corps de carter (11) auquel il est couplé à une zone de non-maintenance (11A) à l'exception de ladite zone de maintenance (11B) sur ledit corps de carter (11) ; et
un couvercle de maintenance (20B) séparé dudit corps de couvercle (20A) et monté sur ladite zone de maintenance (11B) sur ledit corps de carter (11) ; dans laquelle
ledit couvercle de maintenance (20B) est disposé sur une surface extérieure de paroi périphérique (20B-2) avec des cadres flexibles de verrouillage (21), une partie d'actionnement (21a) se projetant de chacun desdits cadres de verrouillage (21) ;
un cliquet de verrouillage (26) est disposé sur ledit corps de couvercle (20A) à une position correspondant à chacun desdits cadres de verrouillage (21) ; et
ledit couvercle de maintenance (20B) est couplé de manière détachable sur lesdits cliquets de verrouillage (26) en déviant lesdits cadres de verrouillage (21) ;
**caractérisée en ce que**
ladite partie d'actionnement (21a) se projette également sur ladite surface extérieure de paroi périphérique (20B-2) dudit couvercle de maintenance (20B).

2. Boîte de raccordement électrique (10) selon la revendication 1, dans laquelle chacun desdits cliquets de verrouillage (26) disposés sur ledit corps de couvercle (20A) se projette d'une surface intérieure d'un trou traversant respectif (25) ouvert dans une surface dudit corps de couvercle (20A), et lesdits cadres de verrouillage (21) dudit couvercle de maintenance (20B) sont respectivement insérés dans lesdits trous traversants (25) pour se mettre en prise avec chacun desdits cliquets de verrouillage (26).

3. Boîte de raccordement électrique (10) selon la revendication 1 ou 2, dans laquelle chacun desdits cadres de verrouillage (21) disposés sur ledit couvercle de maintenance (20B) comprend des parties de charnière (22) et une partie de cadre rectangulaire ayant des éléments de cadre droit et gauche (21b), un élément de cadre supérieur (21a), et un élément de cadre inférieur (21c), ladite partie de cadre rectangulaire étant attachée à travers lesdites parties de charnière (22) à ladite surface extérieure de paroi périphérique (20B-2), ledit élément de cadre supérieur (21a) étant connecté aux dits éléments de cadre droit et gauche (21b) de manière à servir de partie d'actionnement (21a), et ledit élément de cadre inférieur étant apte à se mettre en prise avec un cliquet de verrouillage respectif (26).

4. Boîte de raccordement électrique (10) selon l'une quelconque des revendications 1 à 3, dans laquelle lesdites parties de montage de fusibles (12) formées sur ladite zone de maintenance (11B) sont fermées et ouvertes par ledit couvercle de maintenance (20B), lesdites parties de montage de fusibles (12) sont pourvues de cavités (12a) dans le cas où des fusibles sont attachés aux dites parties (12) et ne sont pas pourvues desdites cavités dans le cas où des fusibles ne sont pas attachés aux dites parties (12), ces parties n'ayant pas de cavités servent de zone de montage de fusibles supplémentaire (13-1, 13-2), et ladite zone de montage de fusibles supplémentaire est apte à être recouverte d'une partie plate interdisant l'accès (13d).

5. Boîte de raccordement électrique (10) selon l'une quelconque des revendications 2 à 4, dans laquelle ladite zone de maintenance (11B) est contiguë à un bord d'extrémité extérieur dudit corps de carter (11) ;
dans laquelle une paroi périphérique et une paroi supérieure dudit corps de couvercle (20A) sont découpées à des positions correspondant à ladite zone de maintenance (11B), et ledit couvercle de maintenance (20B) est monté sur lesdites parties découpées desdites parois ;
dans laquelle ladite partie découpée de ladite paroi périphérique dudit corps de couvercle (20A) se continue jusqu'à une paroi périphérique extérieure dudit couvercle de maintenance (20B) ; et
dans laquelle une paire de parois latérales opposées (20B-3) est fournie sur des extrémités opposées longitudinales de ladite paroi périphérique extérieure, chacune desdites parois latérales opposées est pourvue de chacun desdits cadres de verrouillage (21), lesdites parois latérales opposées sont disposées à l'intérieur de ladite paroi périphérique dudit corps de couvercle (20A), et chacun desdits cadres de verrouillage (21) est mis en prise avec chacun desdits cliquets de verrouillage (26) se projetant des surfaces intérieures desdits trous traversants dans ledit corps de couvercle (20A).
